# EUROPÄISCHE PATENTANMELDUNG

(11) **EP 0 549 528 A1**
(43) Veröffentlichungstag der Anmeldung: **30.06.1993**
(21) Anmeldenummer: 92810985.9
(22) Anmeldetag: 11.12.1992
(51) Int. Cl.: C23C 14/08, C23C 14/10, C23C 14/06, B65D 65/40, C08J 7/00

(54) **Verfahren zur Herstellung von Substraten enthaltend eine Überzugsschicht**

(30) Priorität: 20.12.1991 CH 3801/91
(71) Anmelder: ALUSUISSE-LONZA SERVICES AG, CH-8034 Zürich (CH)
(72) Erfinder: Kessler, Clemens, CH-8107 Buchs (CH); Lohwasser, Wolfgang, CH-8200 Schaffhausen (CH)

(57) **Zusammenfassung**

Verfahren zur Herstellung von Substraten, enthaltend thermoplastische Kunststoffe und eine Überzugsschicht aus anorganischen Verbindungen. Die Überzugsschicht wird durch Verdampfen im Vakuum von anorganischen Stoffen aus Verdampfertiegeln bei Drücken von weniger als 10⁻¹ mbar erzeugt und der Dampf der anorganischen Stoffe wird in einer den Verdampfertiegel und das Substrat umgebenden Kammer erzeugt und auf dem Substrat niedergeschlagen. Dabei kann die Überzugsschicht wenigstens zwei gleichzeitig unmittelbar auf den thermoplastischen Kunststoff abgeschiedene Metall- und/oder Halbmetallverbindungen enthalten. Die anorganischen Stoffe im Verdampfertiegel liegen in einer Rohdichte vor, die 25 bis 75 % der Reindichte beträgt.

## Beschreibung

Die Erfindung betrifft ein Verfahren zur Herstellung von Substraten enthaltend thermoplastische Kunststoffe und eine Überzugsschicht aus anorganischen Verbindungen, wobei die Überzugsschicht durch Verdampfen im Vakuum von anorganischen Stoffen aus Verdampfertiegeln bei Drücken von weniger als 10⁻¹ mbar erzeugt wird, wobei der Dampf der anorganischen Stoffe in einer den Verdampfertiegel und das Substrat umgebenden Kammer erzeugt wird, und der Dampf der anorganischen Stoffe auf dem Substrat niedergeschlagen wird.

Die Erfindung betrifft auch Substrate, hergestellt nach dem erfindungsgemässen Verfahren.

Die Erfindung betrifft ferner die Verwendung der Substrate hergestellt nach vorliegendem erfinderischen Verfahren.

Es ist bekannt, Siliciumoxid durch Vakuumverdampfen oder durch Sputtern auf transparentes Plastikmaterial aufzubringen und aus diesem Plastikmaterial, beispielsweise in Form eines laminierten Films, einen transparenten Behälter herzustellen (EP 0 187 512).

Es ist aus der EP 0 062 334 bekannt, flexible Polymerfilme mit dampfundurchlässigen Beschichtungen zu versehen. Die Beschichtungen bestehen aus zwei Schichtanteilen, einer ersten haftvermittelnden Schicht und einer zweiten Sperrschicht. Zwei verschiedene Schichtanteile bedeuten z.B. einen verdoppelten Herstellungsaufwand für die Schichten.

Das Aufbringen von solchen dünnen Oxidschichten bewirkt eine stark verminderte Gaspenetration durch solcherart beschichtete Kunststoffolien. Beispielsweise beim Verpacken von verderblichen Füllgütern, wie Nahrungsmitteln und Genussmitteln kann in eine Verpackung Luft und damit Sauerstoff oder Wasserdampf, resp. Feuchtigkeit eindringen oder aus einer Verpackung können Aromastoffe, Feuchtigkeit oder unter Druck stehende Gase, wie z.B. Kohlendioxid durch das Verpackungsmaterial an die Umgebung treten.

Durch Sperrschichten oder Barriereschichten, wie z.B. Metallfolien oder Kunststoffolien mit Sperreigenschaften, wie Polyvinylidenchlorid oder durch Siliciumoxid-Schichten kann dieser unerwünschte Stoffaustausch vermindert werden.

Es werden vermehrt auch transparente Verpackungsmaterialien gefordert, eine Vorgabe, die mit Metallfolien nicht erfüllt werden kann. Sperrschichten aus Kunststoff und Metall stören oft die Sortenreinheit der Verpackungsmaterialien und erstere können auch unerwünschte Chloranteile in das Verpackungsmaterial bringen.

Beispielsweise Siliciumoxid-Schichten vermögen bis anhin bezüglich der Farbe noch nicht zu überzeugen. Die Siliciumoxid-Schichten sind an sich mehr oder weniger transparent, weisen jedoch oft eine Färbung z.B. ins gelbliche auf. Sind solche Schichten transparent, ist die Sperrwirkung ungenügend. Bei der Durchsicht durch die Verpackung sind den Inhalt der Packung verfälschende Farbeindrücke unerwünscht. Die Durchlässigkeit von Gasen und Wasserdampf bekannter Verpackungsmaterialien mit oxidischen Schichten ist ebenfalls ungenügend. Verpackungen von z.B. Nahrungsmitteln müssen zudem den Sterilisationsbedingungen widerstehen. Unter solchen Bedingungen darf eine oxidische Schicht nicht abplatzen oder auf einer Folie oder in einem Folienverbund schwächende Eigenschaften entwickeln.

Die Europäische Patentanmeldung 0 460 796 beschreibt verbesserte Siliciumoxid-Beschichtungen auf polymeren Substraten durch "dopen" von SiO₂ mit einem oder mehreren Metallen. Diese Massnahme vermag aber einen Nachteil nicht zu beheben, nämlich das Spritzen des Tiegelinhaltes durch die zugeführte Energie und die dadurch erzeugte Verdampfungswärme. Durch Spritzen des Tiegelinhaltes kann das Substrat geschädigt werden.

Aufgabe vorliegender Erfindung ist es, ein neues Verfahren zur Herstellung der Substrate zur Verfügung zu stellen, das es ermöglicht, die genannten Nachteile zu überwinden und ein Verpackungsmaterial zu schaffen, das im Bereich des sichtbaren Lichtes keinerlei Absorptionen zeigt und völlig transparent ist, geringe Gas- und Wasserdampf- und insbesondere Sauerstoffpenetration zeigt, stark aneinander haftende Schichten aufweist und kostengünstig und fehlstellenfrei herstellbar ist.

Erfindungsgemäss wird dies dadurch erreicht, dass die anorganischen Stoffe in Verdampfertiegel in einer Rohdichte vorliegen, die 25 bis 75 % der Reindichte der anorganischen Stoffe beträgt.

Zweckmässig liegen die anorganischen Stoffe im Verdampfertiegel als Füll-, Klopf-, Press-, Schütt-, Stopf-, Sinter- oder Schaummassen vor.

Ebenfalls zweckmässig liegen die anorganischen Stoffe als Sintermassen mit einer Rohdichte, die 25 bis 75 % der Reindichte der anorganischen Stoffe beträgt, vor.

Bevorzugt beträgt die Rohdichte 40 bis 60 % und insbesondere 50 % der Reindichte der anorganischen Stoffe.

Es kann ein einzelner anorganischer Stoff oder zwei oder mehrere anorganische Stoffe nebeneinander oder im Gemisch angewendet werden.

In weiterer zweckmässiger Ausführungsform des Verfahrens werden wenigstens zwei anorganische Stoffe gleichzeitig unter Ausbildung eines Dampfgemisches im Vakuum verdampft und das Dampfgemisch der anorganischen Stoffe unmittelbar auf den thermoplastischen Kunststoff des Substrates niedergeschlagen wird.

Bevorzugt sind Verfahren, gemäss denen zwei anorganische Stoffe gleichzeitig, unter Ausbildung eines Dampfgemisches, im Vakuum verdampft werden.

Weiters bevorzugt sind Verfahren vorliegender Erfindung, wobei als anorganische Stoffe zwei verschiedene Metalle, Halbmetalle, Metall- und/oder Halbmetallverbindungen gleichzeitig, unter Ausbildung eines Dampfgemisches, im Vakuum verdampft werden.

Bevorzugt sind als anorganische Stoffe die Metalle und Halbmetalle Silicium, Aluminium, Magnesium, Lanthan, Titan, Bor und Zirkon und als Metall- und Halbmetallverbindungen die Oxide, Carbide und Nitride des Siliciums, des Aluminiums, des Magnesiums, des Lanthans, des Titans, des Bors und des Zirkons. Die anorganischen Stoffe können als Gemisch in einem oder mehreren Verdampfertiegeln oder jeder Stoff für sich in einem oder mehreren Verdampfertiegeln vorliegen.

Bevorzugt sind Verfahren nach vorliegender Erfindung, bei denen als anorganische Stoffe zwei Metall- und/oder Halbmetallverbindungen angewendet werden, wobei eine Verbindung ein Oxid des Siliciums und wenigstens eine weitere Verbindung ein Oxid des Aluminiums, des Magnesiums, des Lanthans, des Titans, des Bors oder des Zirkons darstellt.

Besonders bevorzugt werden SiO₂ und Al₂O₃ oder SiO₂ und MgO oder SiO₂ und La₂O₃ oder SiO₂ und TiO₂ oder SiO₂ und ZrO₂ oder SiO₂ und B₂O₃ gleichzeitig aufgedampft.

In weiterer bevorzugter Ausgestaltung vorliegenden Verfahrens wird während der Verdampfung der anorganischen Stoffe das Substrat mit N₂-, Aroder O₂-Ionen beschossen.

Ebenfalls bevorzugt ist ein Verfahren, wobei das Verdampfen und Niederschlagen in reaktiver Atmosphäre erfolgt.

Zweckmässig liegen in dem oder in den Verdampfertiegel/n mindestens 30 Gew.-% SiO₂ vor.

Besonders zweckmässig liegen in dem oder in den Verdampfertiegel/n 50 bis 95 Gew.-% SiO₂ und 50 bis 5 Gew.-% Al₂O₃ oder 50 bis 99 Gew.-% SiO₂ und 50 bis 1 Gew.-% MgO oder 50 bis 95 Gew.-% SiO₂ und 50 bis 5 Gew.-% La₂O₃ oder 50 bis 99 Gew.-% SiO₂ und 50 bis 1 Gew.-% TiO₂ oder 50 bis 90 Gew.-% SiO₂ und 50 bis 10 Gew.-% ZrO₂ oder 70 bis 99,99 Gew.-% SiO₂ und 30 bis 0,01 Gew.-% B₂O₃ vor.

Bevorzugt liegen in dem oder in den Verdampfertiegel/n 50 bis 80 Gew.-% SiO₂ und 50 bis 20 Gew.-% Al₂O₃ oder 80 bis 99 Gew.-% SiO₂ und 20 bis 1 Gew.-% MgO oder 50 bis 80 Gew.-% SiO₂ und 50 bis 20 Gew.-% La₂O₃ oder 80 bis 90 Gew.-% SiO₂ und 20 bis 10 Gew.-% TiO₂ oder 50 bis 70 Gew.-% SiO₂ und 50 bis 30 Gew.-% ZrO₂ oder 80 bis 99,99 Gew.-% SiO₂ und 20 bis 0,01 Gew.-% B₂O₃ vor.

Es ist auch möglich, z.B. mindestens 30 Gew.-%, bevorzugt 50 und mehr Gew.-% und insbesondere 90 und mehr Gew.-% SiO₂ und wenigstens ein Metall und/oder Halbmetall, beispielsweise Al, Mg, La, Ti, Zr oder B, vorzugsweise Aluminium, vorzulegen.

Auch bevorzugt ist die Vorlage von Gläsern, wie z.B. alkaliarmen Borosilikatgläsern, beispielsweise enthaltend neben SiO₂ etwa 30 Gew.-% Boroxid.

Zweckmässig ist die Vorlage von 99 bis 99,99 Gew.-% SiO₂ und 1 bis 0,01 Gew.-% Aluminium.

Anstelle von SiO₂ können auch Verbindungen der Formel SiOₓ, wobei x z.B. eine Zahl von 1 bis 2, bevorzugt 1,1 bis 1,9 und besonders bevorzugt 1,3 bis 1,7 ist, angewendet werden.

Nach der erfindungsgemässen Ausführungsform werden die Metalle, Halbmetalle, Metall- und/oder Halbmetallverbindungen aus der gleichen Atmosphäre auf das Substrat aufgedampft, wobei in einer ersten Ausführungsform die Metalle, Halbmetalle, Metall- und/oder Halbmetallverbindungen allein oder als Gemisch im Verdampfertiegel vorliegen.

Nach einer zweiten bevorzugten Ausführungsform können die Metalle, Halbmetalle, Metall- und/oder Halbmetallverbindungen aus der gleichen Atmosphäre auf das Substrat aufgedampft werden, wobei wenigstens zwei Metalle, Halbmetalle, Metall- und/oder Halbmetallverbindungen jede/s für sich jeweils in einem separaten Tiegel vorgelegt werden.

Die Metalle, Halbmetalle, Metall- und/oder Halbmetallverbindungen weisen nach vorliegender Erfindung eine Rohdichte auf, die 25 bis 75 % der Reindichte entspricht.

Solche Rohdichten sind beispielsweise die Schütt- oder Fülldichten durch lose eingefülltes oder in bestimmter Weise geschüttetes Pulver, Körner oder Fasern zu Haufwerken in den Tiegel. Wird diese Fülldichte durch loses Einfüllen nicht erreicht, können das Pulver, die Körner oder Fasern durch Klopfen dichter gelagert werden, so dass die gewünschte Klopfdichte erreicht wird. Es kann auch durch Anlegen von Pressdruck an das Haufwerk von Pulver, Körnern oder Fasern die geforderte Pressdichte erzielt werden. Beispielsweise können Pressdrücke von 1 bis 100 kg/cm² und zweckmässig von 40 bis 60 kg/cm² angelegt werden.

Beispielsweise kann ein solches Füllgut für den Verdampfertiegel dadurch erzeugt werden, dass die entsprechenden anorganischen Stoffe beispielsweise durch Fällung, Kristallisation, Mahlen, Agglomerieren oder Sieben auf eine Korngrösse von 0,05 bis 1000 µm gebracht werden. Anschliessend können die anorganischen Stoffe kalt und trocken vermischt und als Haufwerk oder, mit oder ohne Binder, wie z.B. Polyvinylalkohol oder Polyvinylacetat, vermischt und verpresst, als Presskörper in einen Verdampfertiegel gegeben werden.

Die Verbindungen können auch durch Lösen oder Gelieren in starken Mineralsäuren, mischen und fällen, z.B. nach dem Sol-Gel-Verfahren, trocknen und in den Verdampfertiegel formen, hergestellt werden.

Andere Verfahren zur Herstellung des Füllgutes aus den Metallen, Halbmetallen, Metall- und/oder Halbmetallverbindungen für den Verdampfertiegel sind z.B. isostatisches uniaxiales Pressen, Extrudieren oder Schlickergiessen des entsprechenden Pulvergemisches. Auch kann man die entsprechenden Materialien zusammen aufschmelzen und nachher in entsprechende Formen giessen oder verdüsen oder versprühen.

Um die gewünschten Rohdichten zu erreichen, insbesondere wenn es sich um Sinterdichten handelt, kann das Füllgut auch mit z.B. organischen Bestandteilen gemischt werden, die während dem Trocknen und/oder Sintern durch Verdampfen oder Verbrennen sich verflüchtigen und Hohlräume hinterlassen. Oder es können Haufwerke oder Presskörper auf die gewünschte Dichte gesintert werden.

Schaummassen sind erhältlich durch imprägnieren eines organischen Schaumes mit dem Füllgut, wobei das Füllgut in Schlickerform gebracht wird, trocknen des Schlickers auf dem organischen Schaum und ausbrennen des organischen Schaumes, wobei das Füllgut in Form eines Abbildes des organischen Schaumes zurückbleibt.

Es ist auch möglich, Schaummassen durch Treibmittel, welche dem Füllgut zugegeben werden, zu erzeugen.

Werden Metalle, Halbmetalle oder Verbindungen davon für sich als Füllgut angewendet, so können diese in gleicher Weise wie Füllgut zu den gewünschten Tiegelinhalten mit den geforderten Rohdichten verarbeitet werden.

Zur Durchführung des erfindungsgemässen Verfahrens werden die Verdampfertiegel in eine Vorrichtung zur Abscheidung von Schichten aus der Gasphase auf einem Substrat gebracht. In der Regel weisen solche Vorrichtungen eine Vakuumkammer, eine Aufnahmevorrichtung für wenigstens einen Tiegel und eine Aufnahmevorrichtung für das Substrat auf.

Zum Verdampfen des Tiegelinhaltes wird der Inhalt entweder direkt über einen Elektronenstrahl oder ein Plasma beheizt und/oder der Tiegel wird induktiv, über eine Widerstandsheizung, über einen Elektronenstrahl und/oder ein Plasma beheizt. Je nach verwendetem Gemisch verdampft der Tiegelinhalt bei Temperaturen von 1100 bis 2000°C. Die dabei entstehende Gasphase hat in den meisten Fällen eine wesentlich andere Zusammensetzung als der Inhalt im Tiegel selbst. Dadurch ergeben sich auch stark veränderte Zusammensetzungen der aus der Gasphase abgeschiedenen Schichten. Die angegebenen Mischungsverhältnisse des Tiegelinhaltes, führen zu den erfindungsgemässen Überzugsschichtzusammensetzungen.

Gasgemische, die zu entsprechenden Überzugsschichtzusammensetzungen führen, können auch durch Absputtern in der Gasphase eines ungefähr der Gasphasenzusammensetzung entsprechend zusammengesetzten Targets (Target= Tiegelinhalt) hergestellt werden. Weiterhin können entsprechende Mischschichten durch Plasma unterstützte CVD-Verfahren abgeschieden werden.

Die Abscheidung der Schichten aus der Gasphase erfolgt auf einem Substrat, das entweder auf Erdpotential liegt oder eine negative oder positive Potentialdifferenz gegenüber der Umgebung besitzt. Die Abscheidung findet im Vakuum statt, wobei in der Regel der verminderte Druck kleiner als 10⁻¹ mbar und zweckmässig kleiner als 10⁻³ mbar ist.

Die aus den anorganischen Stoffen erzeugten Dämpfe werden beispielsweise als solche auf dem Substrat niedergeschlagen. Durch eine reaktive Restatmosphäre können die Dämpfe der anorganischen Stoffe zu neuen oder anderen Verbindungen umgesetzt werden und auch die Dämpfe der wenigstens teilweise umgesetzten Stoffe resp. Verbindungen werden auf dem Substrat niedergeschlagen.

Die Abscheidung kann in einer reaktiven Restgasatmosphäre, beispielsweise bei vermindertem Druck von kleiner als 10⁻³ mbar, ausgeführt werden. Die Restgasatmosphäre kann durch Stickstoff, Sauerstoff, Wasserdampf, Kohlenwasserstoffe, wie Acetylen, usw. gebildet werden.

Durch die reaktive Restatmosphäre können die verdampften anorganischen Stoffe, beispielsweise Metalle in ihre Oxide (mit Sauerstoff) oder in ihre Carbide (z.B. mit Acetylen) umgesetzt werden, resp. Oxide können z.B. zu Carbiden umgesetzt werden.

Vor und/oder während und/oder nach der Abscheidung kann das Substrat mit Ionen aus einer Ionenquelle beschossen werden. Bevorzugt wird das Substrat während der Verdampfung mit N₂-, Ar- oder O₂-Ionen beschossen.

Die bevorzugte Beschichtungsquelle ist ein Elektronenstrahlverdampfer, bei dem ein Tiegel verwendet wird, dessen Länge (z.B. ca. 1 m bis 2,5 m) grösser ist als die Breite (z.B. ca. 0,8 m bis 2,2 m) des an dem Tiegel vorbeigeführten Substrates. Eine oder mehrere Elektronenstrahlkanonen scannen diesen Tiegel ab, wobei Elektronen in den Elektronenstrahlkanonen eine Beschleunigungsspannung von z.B. 30 bis 40 kV durchlaufen. Die pro Meter Tiegel einzubringende Leistung liegt dabei im Bereich von 35 bis 100 kW. Diese Leistung führt bei einer Substrattransportgeschwindigkeit von ca. 200 m/min z.B. zu einer Schichtdicke von ca. 60 nm.

Das erfindungsgemässe Verfahren kann beispielsweise an feststehenden oder kontinuierlich durchlaufenden Substraten ausgeführt werden.

Die dem Verdampfertiegel zugewandte Substratoberfläche kann gegebenenfalls erst gereinigt und aktiviert werden, um eine weitere Verbesserung der Schichthaftung und deren Widerstandsfähigkeit anzustreben.

Das Reinigen und Aktivieren kann beispielsweise durch eine Plasmavorbehandlung erfolgen.

Bei einem kontinuierlichen Verfahren kann das Substrat aufliegend oder frei geführt werden und mit einer Geschwindigkeit von z.B. 1 bis 10 m/sec und insbesondere 3 bis 6 m/sec durch die Vakuumkammmer geführt werden.

Als Substrate sind insbesondere thermoplastische Kunststoffe enthaltende Werkstoffe geeignet.

Die Substrate können als gegossene, extrudierte oder folienförmige Materialien vorliegen. Die Materialien können starr, halbstarr oder flexibel sein.

Als folienförmige Materialien sind z.B. Folien, Laminate, Verbunde oder Schichtstoffe zu nennen. Die folienförmigen Materialien sind in der Regel flexibel.

Die Substrate resp. folienförmige Materialien können thermoplastische Kunststoffe, beispielsweise Thermoplaste auf Olefin-Basis, auf Ester-Basis, auf Polyamid-Basis oder halogenhaltige Kunststoffe, ferner Poly-Acetale, -Acrylate, -Arylensulfide, -Arylensulfone, -Arylencarbonate, -Carbonate, -Imide, -Styrole oder Gemische davon enthalten oder daraus bestehen. Insbesondere können die zu beschichtenden Oberflächen der folienförmigen Materialien die genannten Kunststoffe enthalten oder daraus bestehen.

Beispiele für Thermoplaste auf Olefin-Basis sind Polyolefine, wie Polyethylen, wie Polyethylen hoher Dichte (HDPE, Dichte grösser als 0,944 g/cm³), Polyethylen mittlerer Dichte (MDPE, Dichte 0,926-0,940 g/cm³), lineares Polyethylen mittlerer Dichte (LMDPE, Dichte 0,926-0,940 g/cm³), Polyethylen niedriger Dichte LDPE, Dichte 0,910-0,925 g/cm³) und lineares Polyethylen niedriger Dichte (LLDPE, Dichte 0,916-0,925 g/cm³), Polypropylen, gegossenes Polypropylen, ataktisches oder isotaktisches Polypropylen oder Gemische davon, amorphes oder kristallines Polypropylen oder Gemische davon, Poly-1-buten, Poly-3-methylbuten, Poly-4-methylpenten und Copolymere oder Coextrudate davon und Ionomerharze, wie z.B. von Polyethylen mit Vinylacetat, Acrylsäure, Methacrylsäure, Acrylestern, Tetrafluorethylen oder Polypropylen, sowie statistische Copolymere, Block-Copolymere oder Olefinpolymer-Elastomer-Mischungen.

Thermoplaste auf Ester-Basis sind beispielsweise Polyalkylenterephthalate oder Polyalkylenisophthalate mit Alkylengruppen oder -resten mit 2 bis 10 Kohlenstoffatomen oder Alkylengruppen mit 2 bis 10 C-Atomen, die wenigstens durch ein -0- unterbrochen sind, wie z.B. Polyethylenterephthalat, Polypropylenterephthalat, Polybutylenterephthalat (Polytetramethylenterephthalat), Polydecamethylenterephthalat, Poly-1,4-cyclohexyldimethylolterephthalat oder Polyethylen-2,6-naphthalen-dicarboxylat oder Polyalkylenterephthalat- und Polyalkylenisophthalat-Mischpolymere, wobei der Anteil an Isophthalat z.B. 1 bis 10 Mol-% beträgt, Mischpolymere und Terpolymere, sowie Blockpolymere und gepfropfte Modifikationen oben genannter Stoffe.

Zweckmässig sind die Thermoplaste auf Ester-Basis Polylalkylenterephthalate mit Alkylengruppen oder -resten mit 2 bis 10 Kohlenstoffatomen und Polylakylenterephthalate, mit Alkylengruppen oder -resten mit 2 bis 10 Kohlenstoffatomen, die durch ein oder zwei -0- unterbrochen sind.

Bevorzugt sind als Thermoplaste auf Ester-Basis Polylalkylenterephthalate mit Alkylengruppen oder -resten mit 2 bis 4 Kohlenstoffatomen und ganz besonders bevorzugt sind Polyethylenterephthalate.

Zu den Thermoplasten auf Amid-Basis gehören beispielsweise Polyamid 6, eine Homopolymerisat aus ε-Caprolactam (Polycaprolactan); Polyamid 11, ein Polykondensat aus 11-Aminoundecansäure (Poly-11-aminoundecanamid); Polyamid 12, ein Homopolymerisat und ω-Laurinlactam (Polylaurinlactam); Polyamid 6,6, ein Homopolykondensat aus Hexamethylendiamin und Adipinsäure (Polyhexamethylenadipamid); Polyamid 6,10, ein Homopolykondensat aus Hexamethylendiamin und Sebacinsäure (Polyhexamthylensebacamid); Polyamid 6,12 ein Homopolykondensat aus Hexamethylendiamin und Dodecandisäure (Polyhexamethylendodecanamid) oder Polyamid 6-3-T, ein Homopolykondensat aus Trimethylhexamethylendiamin und Terephthalsäure (Polytrimethylhexamthylenterephthalamid), sowie Gemische davon.

Eine nicht abschliessende Aufzählung von halogenhaltigen Kunststoffen beinhaltet beispielsweise die Polymere des Vinylchlorids und Vinylkunststoffe enthaltend Vinylchlorideinheiten in deren Struktur, z.B. Copolymere des Vinylchlorids mit Vinylestern von alphalischen Säuren, insbesondere von Vinylacetat; Copolymere von Vinylchlorid mit Estern der Acryl- und Methacrylsäure und mit Acrylonitril; Copolymere von Vinylchlorid mit Dien-Verbindungen und ungesättigten Dicarboxylsäuren oder deren Anhydride, wie Copolymere des Vinylchlorids mit Diethylmaleat, Diethylfumarat oder Maleinanhydrid; nachchlorierte Polymere und Copolymere des Vinylchlorids; Copolymere des Vinylchlorids und Vinylidenchlorids mit ungesättigten Aldehyden, Ketonen und anderen, wie Acrolein, Crotonaldehyd, Vinylmethylketon, Vinylmethylether, Vinylisobuylether usw.; Polymere des Vinylidenchlorides und Copolymere desselben mit Vinylchlorid und anderen polymerisierbaren Verbindungen; Polymere des Vinylchloracetates und Dichlorvinylethers, chlorierte Polymere des Vinylacetates, chlorierte polymerische Ester der Acryl- und alphasubstituierten Acrylsäuren; Polymere von chlorierten Styrolen, z.B. Dichlorstyrol, chlorierter Gummi, chlorierte Polymere des Chlorbutadiens und deren Copolymere mit Vinylchlorid; Gummihydrochloride und chlorierte Gummihydrochloride; sowie Mischungen genannten Polymere untereinander oder mit anderen polymerisierbaren Verbindungen und ferner die entsprechenden Bromide und Fluoride.

Die folienförmigen Materialien können auch aus oder mit cellulosehaltigen Materialien wie Papier, Pappe, Karton, papierhaltigen Formmassen etc., hergestellt sein oder mit Hilfe solcher Materialien verstärkt sein.

Die Dicke einer einzelnen Kunststoffolie als Monofilm oder der einzelnen Kunststofffolien in Folienverbunden oder Laminaten kann beispielsweise bei 4 bis 2000 µm, bevorzugt bei 6 bis 600 µm und insbesondere bei 6 bis 150 µm liegen.

Folienverbunde oder Laminate können die an sich bekannten Schichtaufbauten aufweisen, wie z.B. enthaltend wenigstens zwei Kunststoffschichten, oder enthaltend wenigstens eine cellulosehaltige Schicht und wenigstens eine Kunststoffschicht.

Die folienförmigen Materialien können auch auf wenigstens einer Aussenseite eine an sich bekannte Siegelschicht z.B. Polyethylen, LLDPE, LDPE, MDPE, HDPE, Polypropylene, gegossenes Polypropylen, Polyethylenterephthalat und Heissiegllacke enthalten. Solche Siegelschichten können ebenfalls mit einer erfindungsgemässen Überzugsschicht versehen werden.

Alle Substrate können glasklar, getrübt, durchgefärbt, farbbedeckt oder bedruckt angewendet werden.

Die Verbunde und Laminate, wie in vorliegender Beschreibung erwähnt, können auf an sich bekannte Weise, z.B. durch Beschichten, Extrusionsbeschichten, Coextrusionsbeschichten, Kaschieren, Gegenkaschieren oder Heisskalandrieren hergestellt werden.

Die verschiedenen Schichten und insbesondere die Kunststoffolien oder -schichten untereinander, können mit Kaschierklebern und/oder Haftvermittlern und gegebenenfalls Vorlack miteinander zu den Laminaten oder Verbunden verarbeitet werden.

Die Werkstoffe und Verfahren zur Herstellung von Laminaten und Schichtstoffen sind an sich bekannt.

Die durch Verdampfen von Metall- und/oder Halbmetallverbindungen auf das Substrat aufgebrachte Überzugsschicht kann beispielsweise eine Dicke von 5 bis 500 nm, zweckmässig von 10 bis 200 nm und bevorzugt von 40 bis 150 nm aufweisen.

Die Überzugsschicht kann auf ein Substrat, wie z.B. auf eine Folie oder einen Folienverbund, aufgebracht werden und auf die Überzugsschicht kann fallweise eine weitere Folie oder ein weiterer Folienverbund, z.B. gleichen oder ähnlichen Aufbaus wie das Substrat, aufgebracht werden. Zur Erzeugung von Substraten mit mehreren Sperrschichten können z.B. mehrere überzogene Substrate miteinander verbunden werden. Andere Kombinationen sind auch möglich, beispielsweise das gegenseitige Verbinden zweier überzogener Substrate mit der Überzugsschichten gegeneinander.

Es ist zweckmässig, auf die Überzugsschicht eines Substrates wenigstens eine Folie oder ein Folienverbund aus thermoplastischen Kunststoffen aufzubringen. Auch das Substrat kann auf der unbeschichteten Seite mit weiteren Folien oder Folienverbunden beschichtet werden. Beispiele von Folien und Folienverbunden können vorliegender Beschreibung zu den Substraten und folienförmigen Materialien entnommen werden.

Vorliegende Erfindung umfasst auch die Substrate, hergestellt nach dem erfindungsgemässen Verfahren, enthaltend thermoplastische Kunststoffe und eine Überzugsschicht aus anorganischen Verbindungen, wobei die Überzugsschicht wenigstens zwei gleichzeitig unmittelbar auf den thermoplastischen Kunststoff abgeschiedene Metall- und/oder Halbmetallverbindungen, enthaltend ein Gemisch von SiOₓ und Al₂O₃ oder von SiOₓ und MgO oder von SiOₓ und La₂O₃ oder von SiOₓ und TiO₂ oder von SiOₓ und ZrO₂ oder von SiOₓ und B₂O₃, wobei x die Bedeutung einer Zahl von 1 bis 2 hat und SiOₓ zu 50 bis 99,99 Atom-% im Gemisch enthalten ist, aufweist.

Zweckmässig enthalten die Substrate eine Überzugsschicht eines Gemisches von wengistens zwei gleichzeitig abgeschiedenen Metall- und/oder Halbmetallverbindungen aus der Reihe der Oxide, Carbide und Nitride des Siliciums, des Aluminiums, des Magnesiums, des Lanthans, des Titans und des Zirkons.

Bevorzugt enthalten die Substrate eine Überzugsschicht eines Gemisches von zwei gleichzeitig abgeschiedenen Metall- und Halbmetallverbindungen.

Zweckmässig sind Substrate, deren Überzugsschicht zwei gleichzeitig abgeschiedene Metall- und/oder Halbmetallverbindungen der allgemeinen Formel

Si_{1-z}M_{z}O_{2-α-β}N_{α}C_{β}

enthält, wobei α und β die Bedeutung einer Zahl von 0 bis 0,1 haben, M die Bedeutung von Al, B, Mg, La, Ti oder Zr hat und, wenn
M die Bedeutung vom Mg hat, z eine Zahl von 0,001 bis 0,5 ist,
oder
M die Bedeutung vom Ti hat, z eine Zahl von 0,001 bis 0,1 ist,
oder
M die Bedeutung vom B hat, z eine Zahl von 0,001 bis 0,4 ist,
oder
M die Bedeutung vom La hat, z eine Zahl von 0,001 bis 0,1 ist,
oder
M die Bedeutung vom Zr hat, z eine Zahl von 0,001 bis 0,1 ist,
oder
M die Bedeutung vom Al hat, z eine Zahl von 0,001 bis 0,1 ist.

Bevorzugt hat in der genannten allgemeinen Formel M die Bedeutung von Mg, Ti, B, La, Zr oder Al und z ist eine Zahl von 0,001 bis 0,1.

Bevorzugt sind Substrate enthaltend eine Überzugsschicht aus einem Gemisch von SiOₓ und Al₂O₃, oder von SiOₓ und MgO oder von SiOₓ und La₂O₃ oder von SiOₓ und TiO₂ oder von SiOₓ und ZrO₂ oder von SiOₓ und B₂O₃ enthalten, wobei x die Bedeutung einer Zahl von 1 bis 2 hat.

Besonders bevorzugt sind Substrate, die eine Überzugsschicht eines Gemisches von wenigstens einer Metall- und/oder Halbmetallverbindung und 50 bis 99,99 Atom-% SiOₓ, wobei x eine Zahl von 1 bis 2 ist, enthalten.

Bevorzugt hat x in der Formel SiOₓ jeweils die Bedeutung einer Zahl von 1,1 bis 1,5 und insbesondere von 1,3 bis 1,7.

Ganz besonders bevorzugt sind Substrate, die eine Überzugsschicht eines Gemisches von zwei Metall- und/oder Halbmetallverbindungen enthalten und die Überzugsschicht ein Gemisch von 80 bis 99,99 Atom-% SiOₓ und 20 bis 0,01 Atom-% Al₂O₃ enthält, oder die Schicht ein Gemisch von 50 bis 99,99 Atom-% SiOₓ und von 50 bis 0,01 Atom-% MgO enthält oder die Schicht ein Gemisch von 80 bis 99,99 Atom-% SiOₓ und von 20 bis 0,01 Atom-% La₂O₃ enthält oder die Schicht ein Gemisch von 80 bis 99,99 Atom-% SiOₓ und von 20 bis 0,001 Atom-% TiO₂ enthält oder die Schicht ein Gemisch von 80 bis 99,99 Atom-% SiOₓ und von 20 bis 0,01 Atom-% ZrO₂ enthält oder die Schicht 80 bis 99,99 Atom-% SiOₓ und von 30 bis 0,01 Atom-% B₂O₃ enthält, und x die Bedeutung einer Zahl von 1 bis 2 hat.

Insbesondere sind Substrate bevorzugt, deren Überzugsschicht ein Gemisch von 99 bis 99,99 Atom-% SiOₓ und 1 bis 0,01 Atom-% Al₂O₃ oder ein Gemisch von 80 bis 99,99 Atom-% SiOₓ und von 20 bis 0,01 Atom-% MgO oder ein Gemisch von 95 bis 99,99 Atom-% SiOₓ und von 5 bis 0,01 Atom-% La₂O₃ oder ein Gemisch von 95 bis 99,99 Atom-% SiOₓ und von 5 bis 0,01 Atom-% TiO₂ oder ein Gemisch von 95 bis 99,99 Atom-% SiOₓ und von 5 bis 0,01 Atom-% ZrO₂ oder ein Gemisch von 95 bis 99,99 Atom-% SiOₓ und von 5 bis 0,01 Atom-% B₂O₃ enthält, und x die Bedeutung einer Zahl von 1 bis 2 hat.

Im weiteren umfasst vorliegende Erfindung Substrate enthaltend thermoplastische Polymere mit einer Überzugsschicht in Form, wenigstens einer Oberflächen- und/oder Zwischenschicht, beispielsweise in Form einer 5 bis 500 nm, zweckmässig 10 bis 200 nm und bevorzugt 40 bis 150 nm dicken durch Verdampfen im Vakuum aufgebrachten Schicht eines Gemisches von wenigstens zwei Metall- und/oder Halbmetallverbindungen.

Bevorzugt werden Substrate enthaltend thermoplastische Polymere mit einer Überzugsschicht in Form einer wenigstens einer Oberflächen- und /oder Zwischenschicht als eine durch Verdampfen im Vakuum aufgebrachten Schicht eines Gemisches von zwei Metall- und/oder Halbmetallverbindungen aus der Reihe der Oxide, Carbide und Nitride des Siliciums, des Aluminiums, des Magnesiums, des Lanthans, des Titans, des Zirkons und des Bors.

Die beschichteten Substrate nach vorliegender Erfindung und die daraus gefertigten Materialien weisen z.B. eine verminderte oder nahezu vollständige Gas- (z.B. Luft, Sauerstoff, CO₂) und Dampf- (z.B. Wasserdampf) Durchlässigkeit auf.

Die beschichteten Substrate nach vorliegender Erfindung weisen eine gegenüber den unbeschichteten Substraten unveränderte Durchlässigkeit, resp. Adsorption für elektromagnetische Wellen des sichtbaren Lichtes auf und vermindern oder verhindern den Durchgang von elektromagnetischen Wellen im Bereich des UV-Lichtes.

Auch kann Mikrowellenbestrahlung durch ein nach der Erfindung beschichtetes Substrat dringen.

Beispielsweise liegt die Sauerstoffpermeation bei einer 0,1 µm dicken Überzugsschicht auf einem 12 µm dicken PET-Substrat unter 0,05 ccm/d·m²·bar bei 23°C.

Die Schichten der Metall- und/oder Halbmetallverbindungen haften sehr stark auf dem Substrat und widerstehen auch den Bedingungen einer Sterilisation von z.B. 30 min bei 121 °C.

Die nach vorliegender Erfindung beschichteten Substrate eignen sich deshalb bevorzugt für die Verwendung als Verpackungsmaterialien oder Packstoffe oder zur Herstellung von Verpackungsmaterialien oder Packstoffen, wie Verpackungsfolien resp.-laminate. Bei den Substraten nach vorliegender Erfindung wird zweckmässig die Überzugsschicht, beispielsweise durch ein folienförmiges Material, wie durch eine Folie oder einen Folienverbund aus thermoplastischen Kunststoffen, beschichtet. Dadurch wird die Überzugsschicht gegen mechanische Einflüsse geschützt und die Eigenschaften des Substrates können erweitert werden. Insbesondere werden derart verschiedene Verpackungsmaterialien und Packstoffe erzeugt. Aus diesen Verpackungsmaterialien können beispielsweise Verpackungsbehälter, wie Beutel, Sachets, Einwickler, Taschen, Bedeckelungen, Tiefziehpackungen, Menuschalen und dgl. hergestellt werden oder es können Deckelmaterialien für Tiefziehpackungen oder schalenförmige Behälter gefertigt werden. Derartige Behältnisse eignen sich beispielsweise zur Aufnahme von Nahrungsmitteln für Mensch oder Tier oder für Genussmittel, jeweils in fester, pulveriger, flüssiger, gallertiger oder pastöser Form. Weitere Anwendungsgebiete für das Verpackungsmaterial sind Verpackungen für die Pharmazie und Medizin, wie Tablettenverpackungen, Durchdrückpackungen etc. zur Aufnahme von Tabletten, Dragees, Hart- und Weichgelatinekapseln, Produkte aus dem Diagnostika-Bereich, Therapeutika und medizinische Hilfsmittel.

Vorliegende Erfindung betrifft deshalb auch die Verwendung der Substrate, hergestellt nach vorliegender Erfindung, als Verpackungsmaterialien und Packstoffe oder als Ausgangs- oder Vormaterialien für Verpackungsmaterialien und Packstoffe.

### Beispiele

1. Ein Pulvergemisch aus 90 Gew.-% SiO₂ und 10 Gew.-% La₂O₃ wird mit Polyvinylalkohol und einer Petroleumemulsion vermengt, gesiebt und anschliessend mit 50 kg/cm² zwischen Stempel und Matrize verpresst. Anschliessend wird der Presskörper gebrannt, wobei die organischen Bestandteile sich verflüchtigen und die anorganischen Bestandteile derart versintern, dass eine Rohdichte von etwa 50 % erreicht wird.
   In einer Vorrichtung, enthaltend eine Vakuumkammer, einen Substratträger, einen Verdampfertiegel und eine Elektronenstrahlkanone, wird am Substratträger eine PET-Folie der Dicke von 12 µm befestigt und der Verdampfertiegel wird mit dem Sinterkörper aus 90 Gew.-% SiO₂ und 10 Gew.-% La₂O₃ befüllt. Die Vakuumkammer wird auf einen Druck von ca. 10⁻⁶ mbar evakuiert.
   Der Verdampfertiegel wird mit der Energie aus der Elektronenstrahlkanone beaufschlagt. Die Spannung beträgt 10 kV, der Strahlstrom 0,1 mA und die erzeugte Beschichtungsleistung 8 nm/sec. Nach einer Behandlungsdauer von 10 sec scheidet sich eine Überzugsschicht einer Dicke von 80 nm auf der Substratoberfläche ab.
   Die Überzugsschicht auf dem Substrat hat eine Zusammensetzung von 99 Atom-% SiO₂ und von 1 Atom-% La₂O₃. Das Substrat ist voll transparent, weist keine Trübung auf und die Sauerstoffdurchlässigkeit ist kleiner als 0,05 cm³/d·m²·bar bei 23 °C.
   Die Oxide in der Überzugsschicht liegen als Gemisch vor und nicht als übereinanderliegende Schichten.
2. Aus einer pulverförmigen Mischung von 18 Gew.-% B₂O₃ und 82 Gew.-% SiO₂ (Quarzmehl) wird ein plattenförmiger Presskörper mit einer Rohdichte von 50 % der Reindichte hergestellt. Der Presskörper wird in einen Tiegel und der Tiegel in eine Vakuumkammer gegeben. Mittels eines Elektronenstrahls wird der Tiegelinhalt im Vakuum verdampft. Die Länge des mit den plattenförmigen Presskörpern bestückten Tiegels beträgt 1250 mm, wobei der Tiegel quer zur Laufrichtung einer Substratfolie angeordnet ist. In der Vakuumkammer wird eine Substratfolie aus 12 µm dickem Polyester in einer Breite von 1100 mm über den Tiegel geführt. Der Elektronenstrahl erhitzt eine linienförmige Zone im Tiegel quer zur Folienlaufrichtung. Die Leistung des Elektronenstrahls beträgt 70 kW, die Bandgeschwindigkeit der Substratfolie 200 m/min.

Durch die schlechte Wärmeleitung des plattenförmigen Presskörpers und als Folge der geringen Rohdichte des Presskörpers wird durch den Elektronenstrahl nur ein schmaler Streifen erhitzt und angeschmolzen, was zu einer sehr guten Energieausnützung führt. Durch die geringe Menge angeschmolzenen Materials entstehen auch keine Spritzer. Die Substratfolie wird nach beendigtem Versuch der Vakuumkammer entnommen und mit der Substratfolie ein Verbund hergestellt. Zu diesem Zweck wird die Substratfolie mit einer 75 µm dicken cPP-Folie lackkaschiert. Die an diesem Verbund gemessene Sauerstoffbarrierewirkung beträgt bei 23°C 0,5 cm³ (m² 24h bar).

## Patentansprüche

1. Verfahren zur Herstellung von Substraten, enthaltend thermoplastische Kunststoffe und eine Überzugsschicht aus anorganischen Verbindungen, durch Verdampfen im Vakuum von anorganischen Stoffen aus Verdampfertiegeln bei Drücken von weniger als 10⁻¹ mbar, wobei der Dampf der anorganischen Stoffe in einer dem Verdampfertiegel und das Substrat umgebenden Kammer erzeugt wird und sich der Dampf der anorganischen Stoffe auf dem Substrat niederschlägt, dadurch gekennzeichnet, dass die anorganischen Stoffe im Verdampfertiegel in einer Rohdichte vorliegen, die 25 bis 75 % der Reindichte der anorganischen Stoffe beträgt.

2. Verfahren nach Anspruch 1, dadurch gekennzeichnet, dass die anorganischen Stoffe im Verdampfertiegel als Füll-, Klopf-, Press-, Schütt-, Sinter- oder Schaummassen vorliegen.

3. Verfahren nach Anspruch 2, dadurch gekennzeichnet, dass die anorganischen Stoffe mit einer Rohdichte, die 25 bis 75 % der Reindichte der anorganischen Stoffe beträgt, vorliegen.

4. Verfahren nach Anspruch 1, dadurch gekennzeichnet, dass wenigstens zwei anorganische Stoffe gleichzeitig unter Ausbildung eines Dampfgemisches im Vakuum verdampft werden und das Dampfgemisch der anorganischen Stoffe unmittelbar auf den thermoplastischen Kunststoff des Substrates niedergeschlagen wird.

5. Verfahren nach Anspruch 1, dadurch gekennzeichnet, dass zwei anorganische Stoffe gleichzeitig, unter Ausbildung eines Dampfgemisches, im Vakuum verdampft werden.

6. Verfahren nach Anspruch 1, dadurch gekennzeichnet, dass als anorganische Stoffe zwei verschiedene Metalle, Halbmetalle, Metall- und /oder Halbmetallverbindungen gleichzeitig, unter Ausbildung eines Dampfgemisches, im Vakuum verdampft werden.

7. Verfahren nach Anspruch 1, dadurch gekennzeichnet, dass als anorganische Stoffe die Metalle und Halbmetalle Silicium, Aluminium, Magnesium, Lanthan, Titan, Bor und Zirkon und als Metall- und Halbmetallverbindungen die Oxide, Carbide und Nitride des Siliciums, des Aluminiums, des Magnesiums, des Lanthans, des Titans, des Bors und des Zirkons angewendet werden.

8. Verfahren nach Anspruch 1, dadurch gekennzeichnet, dass als anorganische Stoffe zwei Metall- und/oder Halbmetallverbindungen angewendet werden, wobei eine Verbindung ein Oxid des Siliciums und wenigstens eine weitere Verbindung ein Oxid des Aluminiums, des Magnesiums, des Lanthans, des Titans, des Bors oder des Zirkons darstellt.

9. Verfahren nach Anspruch 8, dadurch gekennzeichnet, dass SiO₂ und Al₂O₃ oder SiO₂ und MgO oder SiO₂ und La₂O₃ oder SiO₂ und TiO₂ oder SiO₂ und ZrO₂ oder SiO₂ und B₂O₃ gleichzeitig aufgedampft werden.

10. Verfahren nach Anspruch 1, dadurch gekennzeichnet, dass während der Verdampfung der anorganischen Stoffe das Substrat mit N₂-, Ar- oder O₂-Ionen beschossen wird.

11. Verfahren nach Anspruch 1, dadurch gekennzeichnet, dass das Verdampfen und Niederschlagen in reaktiver Atmosphäre erfolgt.

12. Substrate hergestellt nach dem Verfahren gemäss Anspruch 1, enthaltend thermoplastische Kunststoffe und eine Überzugsschicht aus anorganischen Verbindungen,
dadurch gekennzeichnet, dass
die Überzugsschicht wenigstens zwei gleichzeitig unmittelbar auf den thermoplastischen Kunststoff abgeschiedene Metall- und/oder Halbmetallverbindungen, enthaltend ein Gemisch von SiOₓ und Al₂O₃ oder von SiOₓ und MgO oder von SiOₓ und La₂O₃ oder von SiOₓ und TiO₂ oder von SiOₓ und ZrO₂ oder von SiOₓ und B₂O₃, wobei x die Bedeutung einer Zahl von 1 bis 2 hat und SiOₓ zu 60 bis 99,99 Atom-% im Gemisch enthalten ist, aufweist.

13. Substrate nach Anspruch 12, dadurch gekennzeichnet, dass die Substrate eine Überzugsschicht eines Gemisches von wenigstens zwei Metall- und/oder Halbmetallverbindungen aus der Reihe der Oxide, Carbide und Nitride des Siliciums, des Aluminiums, des Magnesiums, des Lanthans, des Titans und des Zirkons enthalten.

14. Substrate nach Anspruch 12, dadurch gekennzeichnet, dass die Überzugsschicht zwei Metall- und/oder Halbmetallverbindungen der allgemeinen Formel
Si_{1-z}M_{z}O_{2-α-β}N_{α}C_{β}
enthält, wobei α und β die Bedeutung einer Zahl von 0 bis 0,1 haben, M die Bedeutung von Al, B, Mg, La, Ti oder Zr hat und, wenn
M die Bedeutung vom Mg hat, z eine Zahl von 0,001 bis 0,5 ist,
oder
M die Bedeutung vom Ti hat, z eine Zahl von 0,001 bis 0,1 ist,
oder
M die Bedeutung vom B hat, z eine Zahl von 0,001 bis 0,4 ist,
oder
M die Bedeutung vom La hat, z eine Zahl von 0,001 bis 0,1 ist,
oder
M die Bedeutung vom Zr hat, z eine Zahl von 0,001 bis 0,1 ist,
oder
M die Bedeutung vom Al hat, z eine Zahl von 0,001 bis 0,1 ist.

15. Substrate nach Anspruch 12, dadurch gekennzeichnet, dass, wenn M die Bedeutung von Mg, Ti, B, La, Zr oder Al hat, z eine Zahl von 0,001 bis 0,1 ist.

16. Substrate nach Anspruch 12, dadurch gekennzeichnet, dass die Substrate eine Überzugsschicht eines Gemisches von zwei Metall- und/oder Halbmetallverbindungen enthalten und die Überzugsschicht vorzugsweise ein Gemisch von 80 bis 99,99 Atom-% SiOₓ und 20 bis 0,01 Atom-% Al₂O₃ enthält, oder die Schicht ein Gemisch von 50 bis 99,99 Atom-% SiOₓ und von 0,01 bis 50 Atom-% MgO enthält oder die Schicht ein Gemisch von 80 bis 99,99 Atom-% SiOₓ und von 20 bis 0,01 Atom-% La₂O₃ enthält oder die Schicht ein Gemisch von 80 bis 99,99 Atom-% SiOₓ und von 20 bis 0,001 Atom-% TiO₂ enthält oder die Schicht ein Gemisch von 80 bis 99,99 Atom-% SiOₓ und von 20 bis 0,01 Atom-% ZrO₂ enthält oder die Schicht 80 bis 99,99 Atom-% SiOₓ und von 30 bis 0,01 Atom-% B₂O₃ enthält, und x die Bedeutung einer Zahl von 1 bis 2 hat.

17. Substrate nach Anspruch 12, dadurch gekennzeichnet, dass die Überzugsschicht ein Gemisch 99 bis 99,99 Atom-% SiOₓ und 1 bis 0,01 Atom-% Al₂O₃ enthält, oder ein Gemisch von 80 bis 99,99 Atom-% SiOₓ und von 20 bis 0,01 Atom-% MgO oder ein Gemisch von 95 bis 99,99 Atom-% SiOₓ und von 5 bis 0,01 Atom-% La₂O₃ oder ein Gemisch von 95 bis 99,99 Atom-% SiOₓ und von 5 bis 0,01 Atom-% TiO₂ oder ein Gemisch von 95 bis 99,99 Atom-% SiOₓ und von 5 bis 0,01 Atom-% ZrO₂ oder ein Gemisch von 95 bis 99,99 Atom-% SiOₓ und von 5 bis 0,01 Atom-% B₂O₃ enthält, und x die Bedeutung einer Zahl von 1 bis 2 hat.

18. Verwendung der Substrate, hergestellt nach Anspruch 1 als Verpackungsmaterialien und Packstoffe oder als Ausgangs- oder Vormaterialien für Verpackungsmaterialien und Packstoffe.
